# FASCICULE DE BREVET EUROPEEN

(11) **EP 0 948 060 B1**
(45) Date de publication et mention de la délivrance du brevet: **16.07.2008**
(21) Numéro de dépôt: 98105574.2
(22) Date de dépôt: 27.03.1998
(51) Int. Cl.: H01L 31/20, H01L 31/18

(54) **Procédé de fabrication collective de cellules photovoltaïques**
Massen-Herstellungsverfahren von photovoltaischen Zellen
Method of batch manufacture for photovoltaic cells

(43) Date de publication de la demande: 06.10.1999
(73) Titulaire: ASULAB S.A., 2074 Marin (CH)
(72) Inventeur: Saurer, Eric, 2022 Bevaix (CH)
(74) Mandataire: Ravenel, Thierry Gérard Louis

(56) Documents cités:
- EP-A- 0 197 679
- US-A- 5 457 057
- US-A- 5 516 704
- PATENT ABSTRACTS OF JAPAN vol. 010, no. 282 (P-500), 25 septembre 1986 & JP 61 100686 A (SANRITSU KOGYO KK), 19 mai 1986
- PATENT ABSTRACTS OF JAPAN vol. 008, no. 053 (E-231), 9 mars 1984 & JP 58 207680 A (SHARP KK), 3 décembre 1983

## Description

La présente invention concerne un procédé de fabrication d'une pluralité de cellules photovoltaïques et plus particulièrement un procédé pour la fabrication collective d'un lot de telles cellules.

Les cellules photovoltaïqes, plus couramment désignées par cellules solaires, sont des dispositifs à jonction semi-conductrice qui convertissent de l'énergie lumineuse en énergie électrique. La structure typique d'une cellule photovoltaïque comprend essentiellement cinq couches, à savoir une première et une seconde électrodes, et un corps de matériau semi-conducteur composite interposé entre les deux électrodes et comprenant trois couches superposées formant une jonction n-i-p ou p-i-n. L'une des deux électrodes est transparente à la lumière. Lorsque de la lumière atteint les couches formant le corps semi-conducteur photovoltaïque, le dispositif engendre une tension entre les électrodes qui augmente avec l'augmentation de l'intensité lumineuse.

Ces cellules solaires sont largement utilisées dans des produits de grande consommation tels que les montres ou les calculatrices électroniques, ainsi que dans des produits industriels pour la génération d'énergie électrique à partie d'énergie solaire.

La fabrication de ce tue de cellules en lot et à grande échelle est relativement récente et a longtemps été limitée par l'absence de techniques de production de cellules appropriées. Des techniques de production ont toutefois été développées récemment pour réaliser à grande échelle et à faible coût des cellules photovoltaïques fiables.

Le brevet US 4,485,125 décrit un tel procédé de fabrication continue en bande d'une pluralité de cellules solaires. Selon ce procédé, on dépose en continu par plasma des couches de matériaux semi-conducteurs formant au moins une jonction n-i-p ou p-i-n de très haute qualité sur un substrat conducteur souple de bobine à bobine. Le produit obtenu par un tel procédé comprend typiquement une bande de matériau conducteur formant substrat et électrode inférieure, cette bande étant revêtue de trois couches successives de matériaux semi-conducteurs respectivement n-i-p et d'une couche d'un matériau conducteur transparent formant une électrode supérieure. Cette bande peut être large de quelque dizaines de centimètres et longue de quelques dizaines de mètres, et peut être considérée comme une unique cellule photovoltaïque de très grandes dimensions. Elle doit par conséquent être divisée en dispositifs de plus faibles dimensions afin d'être adaptée aux applications finales.

Le brevet US 5,457,057 décrit un procédé de fabrication de cellules photovoltaïques à partir de bandes telles que celles obtenues par le procédé décrit dans le brevet US 4,485,125. Selon ce dernier procédé, la bande est divisée par exemple par cisaillement ou par sciage en cellules individuelles au cours d'une première étape, les cellules individuelles étant ensuite reliées en modules comprenant plusieurs cellules individuelles via des bandes de connexion. L'étape de division de la bande en cellules individuelles entraîne toutefois de nombreux problèmes de courts-circuits au voisinage des arêtes coupées des cellules, en particulier suite à la mise en contact accidentelle de l'électrode supérieure avec l'électrode inférieure. Ce procédé nécessite donc des étapes supplémentaires de contrôle et de test de chaque cellule après découpage. Un tel procédé ne permet donc pas aux cellules issues de l'étape de découpage d'être utilisées telles quelles, et diminue en conséquence le rendement.

Pour remédier à cet inconvénient, le brevet US 5,457,057 propose d'éliminer les défauts résultant de l'étape de découpage au cours de deux étapes ultérieures. Une première étape consiste à isoler sur les cellules individuelles découpées une région active centrale de la région périphérique comprenant les défauts résultant de l'opération de découpage mentionnés. A cette fin, il est proposé d'éliminer les couches de matériaux formant l'électrode supérieure et les matériaux semi-conducteurs formant la jonction n-i-p respectivement p-i-n le long du contour des cellules pour exposer le substrat. L'élimination de ces couches peut être réalisée par rayage, par gravure chimique ou encore à l'aide d'un faisceau laser. Au cours d'une deuxième étape, la région périphérique comportant les défauts de découpage est séparée de la région centrale par découpage du substrat depuis l'arrière de la cellule dans la zone où les couches ont été éliminées. Selon une variante également décrite dans ce procédé, la région périphérique est conservée et utilisée pour réaliser des moyens de connection de la cellule.

L'élimination des couches semi-conductrices formant la jonction est particulièrement délicate car elle nécessite la mise en oeuvre soit de produits chimiques très agressifs soit de procédé délicat d'ablation desdites couches par laser ou par rayage qui elles aussi peuvent être source de courts-circuits.

Par ailleurs, une conservation de la région périphérique conduit à une cellule dont l'encombrement peut être plus important pour une région active donnée. Or, cet encombrement supplémentaire peut constituer une limitation considérable à l'utilisation de ces cellules dans certaines applications dans lesquelles elles doivent être incorporées dans des objets de petites dimensions tels que des montres-bracelets ou analogue.

La présente invention a donc pour but principal de remédier aux inconvénients de l'art antérieur susmentionné en fournissant un procédé de fabrication collective de cellules photovoltaïques dans lequel on réalise en un seul lot une pluralité de cellules photovoltaïques, ce lot pouvant ensuite être divisé aisément en cellules individuelles sans risque d'endommagement des cellules et sans risque de création de courts-circuits entre les différentes couches formant chaque cellule.

A cet effet, et selon un premier aspect, l'invention a pour objet un procédé de fabrication collective d'un lot de cellules photovoltaïques individuelles, chaque cellule comportant :
- un substrat électriquement conducteur formant une première électrode,
- une deuxième électrode transparente ou semi-transparente et un corps semi-conducteur photovoltaïque formant la jonction disposé entre la première et la deuxième électrodes,
   le procédé étant caractérisé en ce qu'il comporte au moins les étapes suivantes :
   (a) se munir d'au moins une bande d'un matériau conducteur,
   (b) étamper successivement dans ladite bande des substrats formant les électrodes inférieures selon une ligne de découpe définissant sensiblement la forme et les dimensions des cellules souhaitées,
   (c) replacer les substrats découpés dans la bande aux endroits où il ont été découpés,
   (d) déposer sur une des faces de la bande des matériaux semi-conducteurs formant au moins une jonction n-i-p ou p-i-n , pour former ledit corps semiconducteur photovoltaïque,
   (e) déposer une couche transparente ou semi-transparente d'un matériau électriquement conducteur au-dessus desdits matériaux semi-conducteurs pour former une électrode supérieure, et
   (f) extraire de la bande les substrats découpés revêtus desdits matériaux semi-conducteurs et de l'électrode supérieure pour former des cellules photovoltaïques individuelles.

L'utilisation de la technique consistant à étamper dans une bande de matériau conducteur des substrats aux dimensions d'une cellule individuelle désirée, puis de replacer les substrats découpés dans la bande aux endroits même où ils ont été découpés, est une technique de découpage simple, fiable, rapide et par conséquent particulièrement économique.

De plus, ce procédé permet, avant l'étape d'extraction, de réaliser sur la bande une suite d'opérations en vue de la réalisation d'une pluralité de cellules photovoltaïques finies, y compris notamment l'opération de report d'inscriptions sur les cellules dans le cas où celles-ci sont destinées à former des cadrans pour pièces d'horlogerie ou analogue ainsi que le cas échéant les dépôt de contact ce qui facilite la connexion des cellules individuelles terminées.

Ce procédé est particulièrement intéressant par rapport aux procédés de l'art antérieur en ce que l'extraction des cellules individuelles de la bande de matériau conducteur est réalisée par une simple pression sur les cellules, et ne nécessite donc pas l'utilisation d'un dispositif de découpage par laser ou au jet d'eau complexe et coûteux à mettre en oeuvre. Par ailleurs, après extraction de la bande, les cellules individuelles n'ont plus besoin d'être soumises à des étapes de traitement ultérieur à l'exception, le cas échéant, d'une étape de test. Le procédé selon l'invention fournit donc des cellules prêtes à l'emploi.

Selon un deuxième aspect, l'invention a également pour objet un procédé de fabrication collective d'un lot de cellules photovoltaïques individuelles, chaque cellule comportant :
- un substrat électriquement conducteur formant une première électrode,
- une deuxième électrode transparente ou semi-transparente et un corps semi-conducteur photovoltaïque disposé entre la première et la deuxième électrodes,
   le procédé étant caractérisé en ce qu'il comporte au moins les étapes suivantes :
   (a) se munir d'au moins une bande d'un matériau conducteur,
   (b) découper successivement dans ladite bande des substrats formant les électrodes inférieures pour chaque cellule et ayant la forme et les dimensions des cellules souhaitées, de sorte que chacun desdits substrats soit relié au reste de la bande par au moins un pont de matière,
   (c) déposer sur une des faces de la bande des matériaux semi-conducteurs formant au moins une jonction n-i-p ou p-i-n,
   (d) déposer une couche transparente ou semi-transparente d'un matériau électriquement conducteur au-dessus desdits matériaux semi-conducteurs pour former une électrode supérieure, à l'exception du ou des ponts de matière,
   (e) extraire de la bande, par découpage du ou des ponts de matière non recouverts de ladite couche transparente ou semi-transparente, les substrats revêtus desdits matériaux semi-conducteurs et de l'électrode supérieure pour former des cellules photovoltaïques individuelles.

Grâce à ces caractéristiques, on évite tout problème de court-circuit pourvant résulter éventuellement, du fluage de l'électrode supérieure lors de l'extraction par découpage des cellules individuelles terminées, dans la mesure où le matériau conducteur à été supprimé au-dessus des ponts de matière destinés à être découpés.

De façon avantageuse, on notera également que, conformément au procédé selon l'invention, les cellules maintenues sur la bande conductrice par lesdits ponts de matière sont isolées électriquement les unes des autres. Cela permet notamment de tester les cellules alors qu'elles sont toujours en bandes et de marquer les cellules défectueuses. Une fois marquées, on pourra ignorer les opérations de traitement ultérieur des cellules défectueuses, telles que les opérations de transfert d'inscriptions ou de motifs décoratifs, notamment lorsque ces cellules sont destinées à former des cadrans pour pièces d'horlogerie ou analogue.

Selon une caractéristique avantageuse commune aux deux aspects de l'invention, la bande est découpée en barrettes, comprenant chacune un nombre prédéterminé de cellules, avant l'exécution de l'étape de dépôt desdits matériaux semi-conducteurs et de la couche de matière transparente ou semi-transparente.

Selon une autre caractéristique avantageuse commune aux deux aspects de l'invention, la couche des matériaux semi-conducteurs est déposée selon un procédé au plasma, tandis que la couche transparente ou semi-transparente formant l'électrode supérieure est déposée par évaporation sous vide. On notera que ce dernier procédé est directionel et ne recouvre pas ou peu les flancs perpendiculaire au plan du substrat.

Cette caractéristique est particulièrement avantageuse en liaison avec le deuxième aspect de l'invention. En effet, le dépôt par plasma de la couche des matériaux semi-conducteurs conduit au recouvrement des arêtes et des flancs extérieurs de chaque substrat formant l'électrode inférieure, de sorte que le substrat est parfaitement isolé électriquement de la couche transparente ou semi-transparente qui est déposée ultérieurement étant donné la résistivité élevée des couches semi-conductrice formant la jonction. On évite ainsi l'aménagement d'une marge à la périphérie de chaque cellule, ce qui permet d'augmenter la surface effective de chaque cellule. Cela améliore par ailleurs l'esthétique de la cellule, ce qui est important dans la cas de l'utilisation d'une telle cellule à des cadrans de pièces d'horlogerie.

D'autres caractéristiques et avantages de la présente invention apparaîtront dans la description suivante d'un mode de réalisation préféré du procédé selon l'invention, présenté à titre d'exemple non limitatif en référence aux dessins annexés, dans lesquels :
- la figure 1 est une vue schématique en perspective d'une bande dans laquelle les éléments formant substrat et électrode inférieure des cellules sont étampés puis remis en bande selon un premier mode de réalisation du procédé de l'invention, la bande étant ultérieurement découpée en barrettes;
- la figure 2 est une vue en coupe partielle selon la ligne II-II de la figure 1 d'une barrette revêtue des matériaux semi-conducteurs formant une jonction n-i-p ou p-i-n semi-conducteur photovoltaïque et de l'électrode supérieure avant l'étape d'extraction des cellules individuelles;
- la figure 3 est une vue similaire à celle de la figure 2 après l'étape d'extraction;
- la figure 4 est une vue similaire à celle de la figure 2 d'une variante de mise en oeuvre du procédé selon l'invention;
- la figure 5 est une vue de dessus de la cellule photovoltaïque représentée sur la figure 4 détachée de la barrette;
- la figure 6 est une vue schématique en perspective d'une bande dans laquelle les substrats formant les électrodes inférieures des cellules sont découpés selon un deuxième mode de mise en oeuvre du procédé de l'invention, la bande ayant été découpée en barrettes;
- la figure 7 est une vue en perspective partielle d'une barrette avant l'étape de dépôt du matériau destiné à former l'électrode supérieure;
- la figure 8 est une vue en coupe selon la ligne VIII-VIII de la figure 7;
- la figure 9 est une vue en coupe selon la ligne IX-IX de la figure 7 après l'étape de dépôt de l'électrode supérieure, et
- la figure 10 est une vue en coupe similaire à celle de la figure 9 lors de l'étape de découpage en cellules individuelles.

La description de l'invention va être faite dans le cadre d'une application à la fabrication d'une cellule photovoltaïque circulaire formant un cadran pour une pièce d'horlogerie telle qu'une montre. Il va toutefois de soi que l'invention n'est nullement limitée à cette application, et qu'elle pourra être utilisée dans le cadre de la fabrication de cellules photovoltaïques de tout autres formes et appliquées à tout autres types d'instruments électriques, notamment à faible consommation.

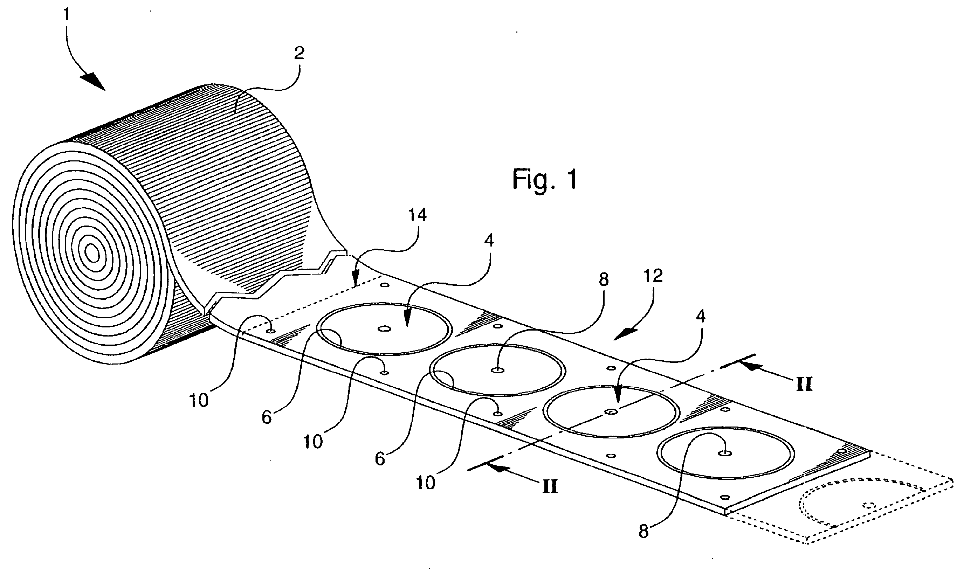

En se référant tout d'abord aux figures 1 à 5, on va décrire un premier mode de réalisation du procédé selon l'invention.

La figure 1 illustre une bande 2 de matériau électriquement conducteur destinée à former le substrat 4 constituant l'électrode inférieure 4 d'une pluralité de cellules photovoltaïques individuelles comprenant notamment les couches semiconductrices formant la jonction des cellules. La bande 2 est typiquement en acier inoxydable. Bien entendu, d'autres matériaux métalliques, compatibles avec la nature des couches semiconductrices formant la jonction dans les conditions de dépôt de celles-ci, pourraient être envisagés.

Selon une variante, la bande 2 peut être réalisée en un matériau isolant et revêtue sur une de ses faces d'une couche d'un matériau électriquement conducteur. Par bande électriquement conductrice, on comprendra donc dans la suite du texte une bande en un matériau métallique ou une bande en un matériau isolant revêtue d'une couche d'un matériau conducteur.

Dans l'exemple représenté sur la figure 1, la bande 2 est délivrée à partir d'une bobine 1 qui alimente un poste d'étampage (non représenté). Dans ce poste, des substrats 2 sont étampés successivement à l'aide d'un poinçon et d'une matrice appropriés selon une ligne de découpe 6 définissant sensiblement la forme et les dimensions finales des cellules photovoltaïques souhaitées.

On notera que, dans ce cas particulier, le poinçon et la matrice sont prévus pour former, simultanément au découpage du contour des cellules, un perçage 8 sensiblement au centre de chaque substrat 4 pour permettre le passage ultérieur des axes sur lesquels seront fixées les aiguilles de la pièce d'horlogerie que le cadran photovoltaïque est destiné à équiper. On prévoit également des perforations d'indexage et d'entraînement 10 permettant d'assurer un positionnement précis des barrettes lors d'opérations ultérieures telles que le décalcage d'un motif sur les cellules terminées.

Immédiatement après l'opération d'étampage, les substrats 2 découpés sont replacés dans la bande 2 aux endroits où ils ont été découpés selon une technique appelée remise en bande. On notera que la partie découpées est maintenues dans la bande par des microsoudures qui se crées spontannément lorsque la pièce étampée est chassée dans l'endroit de la bande dont elle provient.

Après cette opération de remise en bande des substrats 2, la bande 2 est découpée en barrettes telles que 12 comprenant chacune un nombre déterminé de substrats 2, classiquement une dizaine. Une ligne de découpe 14 de la bande 2 en barrettes 12 est représentée par un trait en pointillés sur la figure 1. L'opération de découpage de la bande 2 en barrettes 12 est typiquement réalisée par étampage, cisaillement, sciage ou par tout autre moyen connu de l'homme du métier. Le découpage de la bande 2 en barrettes 12 a pour avantage que les barrettes 12 peuvent être aisément maintenues plates et donc manipulées sans risque de voir les substrats 4 se détacher suite à une courbure excessive desdites barrettes 12 créant dans la bande des contraintes susceptible de rompre la liaison du substrat découpé à la bande dans laquelle il a été réintroduit.

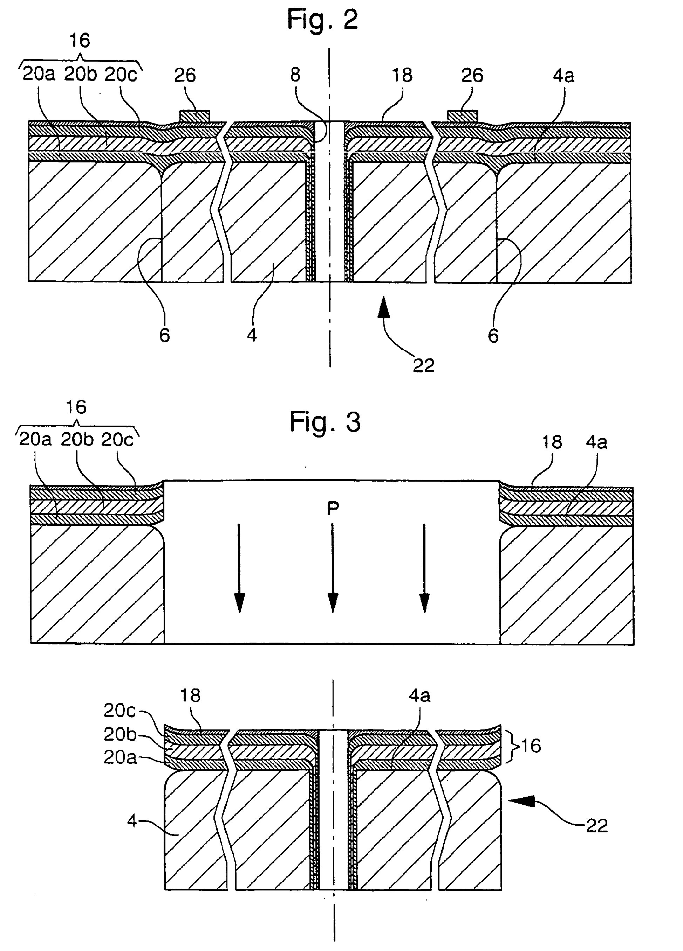

Les barrettes 12 sont ensuite placées dans des cassettes de rangement et introduites ultérieurement dans différentes enceintes successives dans lesquelles on dépose sur la face avant 4a des substrats 4 des matériaux semi-conducteurs formant au moins une jonction n-i-p ou p-i-n 16 puis une couche transparente ou semi-transparente 18 d'un matériau électriquement conducteur au-dessus des matériaux semi-conducteurs 16 (figures 2 et 3) l'ensemble formant la structure de la cellule photovoltaïque.

Les matériaux semi-conducteurs 16 sont déposés selon un procédé plasma classique PECVD (Plasma Enhanced Chemical Vapor Deposition) décrit par exemple dans le document Electronic materials édité par Miller & Mullin Plenum Press New York en 1991 au chapitre " Amorphous Silicon Electronics " pages 143 et suivantes.

Comme il ressort des figures 2 et 3, la structure de la cellule photovoltaïque comprend trois couches minces 20a, 20b et 20c respectivement p-i-n ou n-i-p, disposées en sandwich entre le substrat 4 et la couche 18 qui forme l'électrode supérieure de la cellule photovoltaïque.

Typiquement dans le cas d'une jonction p-i-n, la couche 20a est une couche de silicium amorphe hydrogéné (a-Si:H) dopée avec du bore pour obtenir une conductivité de type p, la couche 20b est une couche intrinsèque i et la couche 20c est une couche de silicium amorphe hydrogéné (a-Si:H) dopée avec du phosphore pour obtenir une conductivité de type n.

La couche transparente ou semi-transparente 18 est déposée de façon classique par évaporation sous vide. Dans le cas d'une couche transparente, la couche 18 est typiquement réalisée en un mélange d'oxyde d'indium et d'étain ITO. Dans le cas d'une couche semi-transparente, la couche 18 est typiquement une couche métallique par exemple d'aluminium, d'argent, de platine, de palladium, de nickel, de titane ou de rhodium ou d'or.

On notera que le dessin ne reflète pas les dimensions exactes des différentes couches, les dimensions ayant été fortement exagérées à des fins d'illustration et de clarté. Pour fixer les idées, l'épaisseur de la bande 2 est typiquement de l'ordre de 0,5 millimètres, l'épaisseur des couches 20a et 20c est typiquement de l'ordre de 10 à 30 nanomètres, l'épaisseur de la couche 20b est typiquement de l'ordre de 50 à 500 nanomètres, et l'épaisseur de la couche 18 est de l'ordre de 50 à 200 nanomètres lorsqu'il s'agit d'une couche transparente, et de l'ordre de 20 à 50 nanomètres lorsqu'il s'agit d'une couche semi-transparente.

Après dépôt des couches 20a, 20b, 20c et 18, on extrait de chaque barrette 12 les substrats 2 prédécoupés et revêtus afin d'obtenir des cellules photovoltaïques individuelles telles que 22 prêtes à l'emploi. Pour ce faire, on applique une pression au droit de chaque cellule 22 à extraire, du côté de l'électrode 18 comme cela est représenté sur la figure 3. Cette opération peut par exemple être exécutée automatiquement à l'aide d'un simple piston qui pousse la cellule 22 vers le bas. On notera que lors de l'extraction, les couches 20a, 20b, 20c et 18 sont rompues, le mouvement d'extraction vers le bas tendant à remonter l'ensemble de ces couches vers le haut. Ce procédé d'extraction est particulièrement avantageux dans la mesure où l'électrode supérieure 18 s'éloigne de l'électrode inférieure 4 avec laquelle elle est susceptible de créer un court-circuit.

Selon une variante de mise en oeuvre du procédé, on peut prévoir d'éliminer le matériau de la couche 18 dans une zone périphérique 24 de chaque cellule individuelle 22 préalablement à l'étape d'extraction, afin d'isoler électriquement les cellules 22 les unes des autres. Une fois isolées, les cellules 22 présentent l'avantage de pouvoir être testées électriquement alors quelles sont encore solidaires de la barrette 12. L'élimination du matériau de la couche 18 dans la zone 24 est réalisée classiquement par exemple à l'aide d'un masque en résine photosensible déposé au-dessus de la couche 18 et exposant à la lumière UV les parties de cette couche 18 que l'on souhaite protéger et dissoudre ensuite la partie de la résine non exposée. L'élimination des parties apparentes de la couche 18 est typiquement réalisée par gravure chimique, par exemple à l'aide d'une solution d'attaque compreant 4 parts d'acide phosphorique 4 parts d'acide acétique une part d'acide nitrique et une part d'eau lorsque le matériau de la couche 18 est l'aluminium. Le masque de protection est ensuite éliminé de la surface de la barrette 12. On notera à ce propos que la zone périphérique 24 s'étend partiellement dans la surface de chaque cellule individuelle 22.

Une variante de réalisation du procédé pourrait bien entendu consister à déposer une laque de protection sur la zone 24 avant le dépôt du matériau de l'électrode 18, déposer le matériau 18 sur la couche 16 et sur le masque de laque recouvrant la zone 24 puis éliminer par dissolution le masque de laque et le matériau de de la couche 18 pour faire appaître la zone 24.

Le présent procédé peut comprendre en outre, avant l'étape d'extraction, une étape de formation d'au moins une plage de contact 26 au-dessus de l'électrode supérieure 18 pour chaque cellule 22. La plage de contact 26 est réalisée par exemple par dépôt d'un matériau fortement conducteur tel qu'une pâte métallique, une laque conductrice ou analogue. On notera que la plage de contact 26 s'étend préférentiellement de façon continue sur toute la périphérie de la cellule 22 afin de minimiser sa résistance série, sans toutefois s'étendre au-dessus de la ligne de découpe 6.

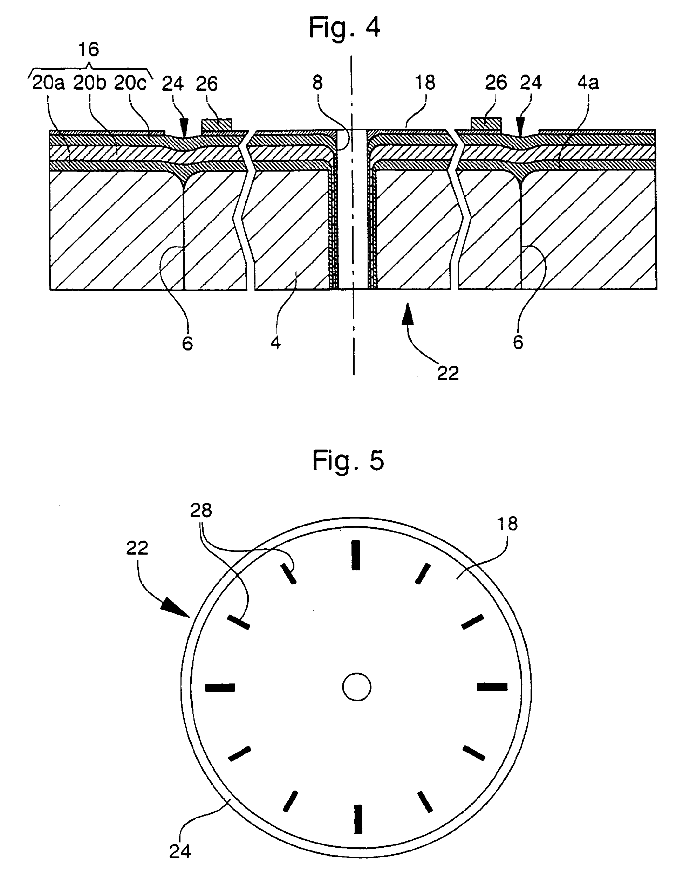

Le procédé de l'invention peut comprendre en outre une étape consistant à reporter, pour chaque cellule 22, un motif et/ou des inscriptions tels qu'un index de tour d'heure 28 (figure 5) à la surface de l'électrode supérieure 18. Cette étape est de préférence effectuée avant l'étape d'extraction et le cas échéant avant l'étape de test électrique des cellules, de sorte que l'étape de report n'est effectuée que sur les cellules 22 déclarées fonctionnelles.

Une fois réalisées, les cellules 22 peuvent être conditionnées sous toute forme appropriée facilitant leur manipulation ultérieure.

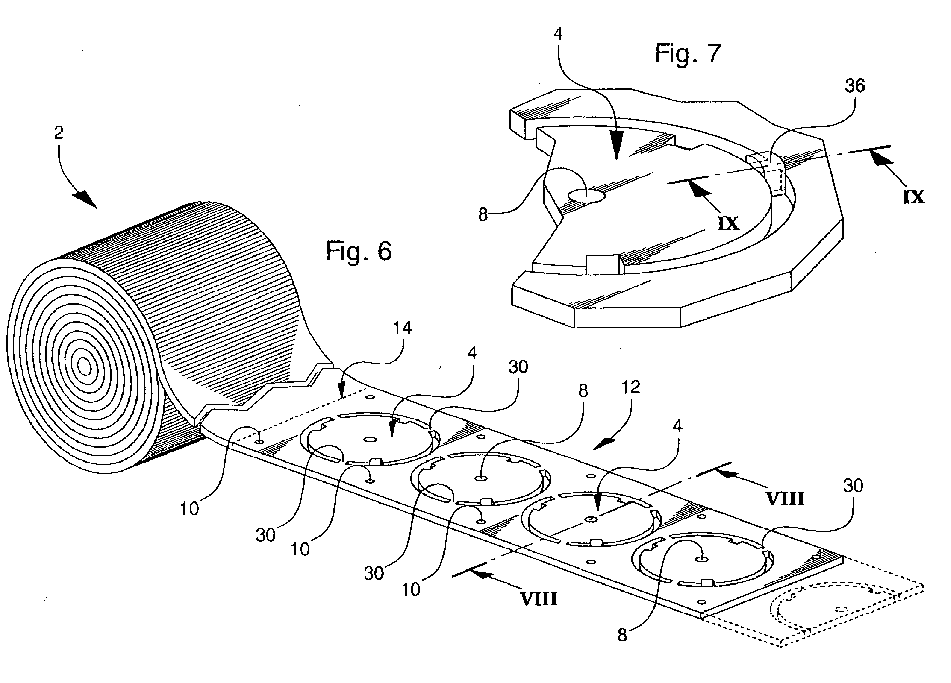

En se référant maintenant aux figure 6 à 10, on va décrire un deuxième mode de réalisation du procédé selon l'invention. Sur ces figures, les éléments identiques à ceux décrits en liaison avec les figures 1 à 5 ont été désignés par les mêmes référence numériques.

A la différence du mode de réalisation représenté aux figures 1 à 5, les substrats 2 sont découpés dans la bande 2 de sorte que chacun de ces substrats 2 reste relié au reste de la bande 2 par au moins un pont de matière 30. Pour des raisons de rapidité et de simplicité, cette opération de découpage est réalisée de préférence par étampage à l'aide d'un poinçon et d'une matrice ayant une forme appropriée correspondant au contour de la cellule 22 souhaitée. Comme dans le mode de réalisation précédent, les perçages 8 sont réalisés en même temps que l'étampage du contour du substrat 4. Il va de soi que d'autres moyens de découpage peuvent être envisagés. On mentionnera à ce propos notamment le découpage par faisceau laser et le découpage au jet d'eau haute pression.

Le nombre de ponts de matière 30 reliant chaque substrat 4 au reste de la bande 2 varie en fonction de la forme dudit substrat 4. Typiquement, ces ponts 30 sont au nombre de trois régulièrement répartis à la périphérie du substrat 4 dans le cas d'un substrat circulaire. Dans le cas d'un substrat rectangulaire, ces ponts 30 peuvent être au nombre de quatre soit, par exemple, un à chaque angle du substrat 4.

La bande 2 étampée est ensuite découpée en barrettes 12 qui sont disposées à plat dans des cassettes en vue du dépôt ultérieur des matériaux semi-conducteurs formant la jonction n-i-p ou p-i-n 16 conformément à ce qui a déjà été décrit en liaison avec le premier mode de mise en oeuvre de l'invention.

On remarquera que cette opération de dépôt par plasma recouvre non seulement la face avant 4a des substrats 4, mais aussi les arêtes telles que 32 et les flancs extérieurs tels que 34 de ceux-ci, avec toutefois une épaisseur moindre.

L'étape suivante consiste à déposer la couche transparente ou semi-transparente 18 au-dessus des matériaux semi-conducteurs 16.

Selon ce mode de réalisation, et pour éviter tout problème de court-circuit entre l'électrode supérieure 18 et le substrat 4 induit lors de l'étape ultérieure d'extraction des cellules 22 des barrettes 12 par découpage des ponts de matière 30, ces ponts 30 doivent être exempts du matériau formant l'électrode supérieure 18.

Pour ce faire, on protège les ponts 30 à l'aide d'un matériau de protection 36 telle qu'une laque ou résine de protection préalablement à l'exécution de l'étape de dépôt de la couche 18 qui s'effectue comme cela a été décrit précédemment en liaison avec le premier mode de réalisation. Typiquement, le matériau de protection 36 est une résine synthétique qui est déposée automatiquement sous la forme d'une goutte par un distributeur et qui est éliminée par exemple par dissolution de la résine après le dépôt de la couche 18, éliminant simultanément le matériau de couche 18 au droit des ponts 30.

Selon une variante, il est bien entendu possible de ne pas déposer de matériau de protection avant le dépôt de la couche 18, mais d'éliminer le matériau formant cette couche se trouvant au-dessus des ponts 30 après coup, par exemple par une attaque chimique sélective au moyen d'un masque de protection de forme appropriée.

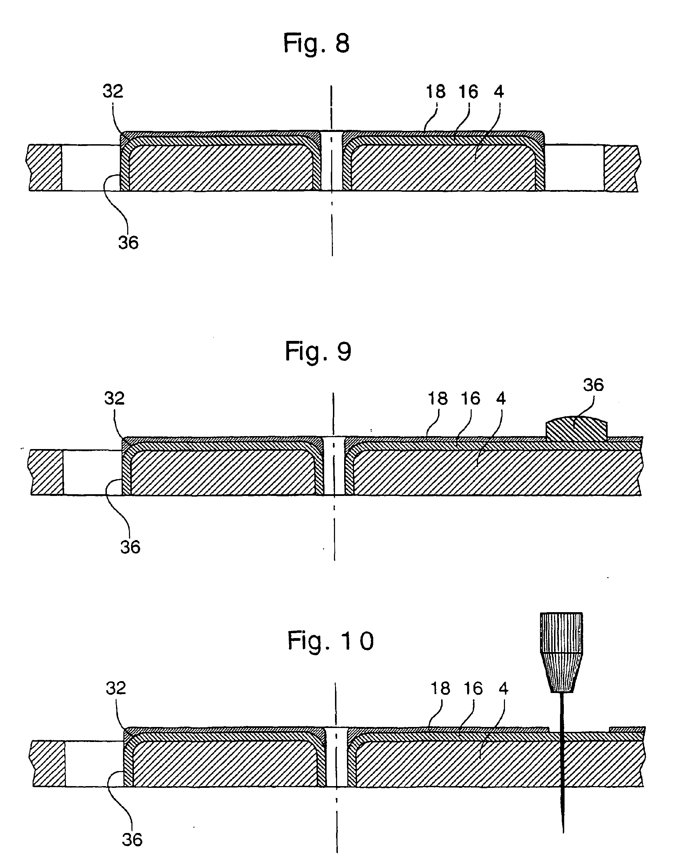

Les cellules 22 sont ensuite extraites des barrettes 12 par découpage, pour former des cellules photovoltaïques individuelles 22 prêtes à l'emploi. De préférence, le découpage est réalisé par étampage à l'aide d'un poinçon 38 partiellement représenté sur la figure 10. Bien entendu on peut envisager la découpage à l'aide d'un faisceau laser ou encore par jet d'eau.

De façon similaire au procédé du premier mode de réalisation, ce procédé peut comprendre en outre, avant l'étape d'extraction, une étape de formation de plages de contact 26, une étape de test électrique des cellules 22, et une étape de transfert de motifs et/ou d'inscriptions.

## Revendications

1. Procédé de fabrication collective d'un lot de cellules photovoltaïques individuelles (22), chaque cellule (22) comportant :
- un substrat (2) électriquement conducteur formant une première électrode (4),
- une deuxième électrode (18) transparente ou semi-transparente et un corps semi-conducteur photovoltaïque (16) formant la jonction disposé entre la première et la deuxième électrode (4, 18),
le procédé étant **caractérisé en ce qu'**il comporte au moins les étapes suivantes :
(a) se munir d'au moins une bande (1) d'un matériau conducteur.
(b) étamper successivement dans la bande (1) des substrats (2) formant les électrodes inférieures (4) selon une ligne de découpe (6) définissant sensiblement la forme et les dimensions des cellules (22) souhaitées,
(c) replacer les substrats (2) découpés dans la bande (1) aux endroits où il ont été découpés,
(d) déposer sur une des faces (4a) de la bande des matériaux semi-conducteurs formant au moins une jonction n-i-p ou p-i-n pour former ledit corps semi-conducteur photovoltaïque (16),
(e) déposer une couche transparente ou semi-transparente d'un matériau électriquement conducteur au-dessus desdits matériaux semi-conducteurs pour former une électrode supérieure (18),
(f) extraire de la bande (1) les substrats (2) découpés revêtus desdits matériaux semi-conducteurs et de l'électrode supérieure (18) pour former des cellules photovoltaïques individuelles (22).

2. Procédé de fabrication collective d'un lot de cellules photovoltaïques individuelles (22), chaque cellule (22) comportant :
- un substrat (2) électriquement conducteur formant une première électrode (4),
- une deuxième électrode (18) transparente ou semi-transparente et un corps semi-conducteur photovoltaïque (16) disposé entre la première et la deuxième électrodes (4, 18),
le procédé étant **caractérisé en ce qu'**il comporte au moins les étapes suivantes :
(a) se munir d'au moins une bande (1) d'un matériau conducteur,
(b) découper successivement dans ladite bande (1) des substrats (2) formant les électrodes inférieures (4) pour chaque cellule (22) et ayant la forme et les dimensions des cellules (22) souhaitées, de sorte que chacun desdits substrats (2) soit relié au reste de la bande (1) par au moins un pont de matière (30),
(c) déposer sur une des faces (4a) de la bande (1) des matériaux semi-conducteurs fomant au moins une jonction n-i-p ou p-i-n (16),
(d) déposer une couche transparente ou semi-transparente d'un matériau électriquement conducteur au-dessus desdits matériaux semi-conducteurs (16) pour former une électrode supérieure (18) à l'exception du ou des ponts de matière (30),
(e) extraire de la bande (1), par découpage du ou des ponts de matière (30) non recouverts de ladite couche transparente ou semi-transparente, les substrats (2) revêtus desdits matériaux semi-conducteurs (16) et de l'électrode supérieure (18) pour former des cellules photovoltaïques individuelles (22).

3. Procédé selon l'une quelconque des revendications 1 ou 2, **caractérisé en ce que** la bande (1) est découpée en barrettes (12) comprenant chacune un nombre prédéterminé de substrats (2) avant l'exécution de l'étape de dépôt des matériaux semi-conducteurs (16) et de la couche transparente ou semi-transparente de matériau électriquement conducteur.

4. Procédé selon l'une quelconque des revendications 1 à 3, **caractérisé en ce qu'**il comprend en outre une étape consistant à former pour chaque cellule (22) une plage de contact (26) avec l'électrode supérieure (18).

5. Procédé selon la revendication 4 en dépendance de la revendication 1, **caractérisé en ce que** la plage de contact (26) est ménagée à la périphérie de la cellule (22) de sorte qu'elle ne s'étend pas au-dessus de la ligne de découpe (6).

6. Procédé selon l'une quelconque des revendications 4 ou 5, **caractérisé en ce que** les plages de contact (26) sont continues et s'étendent sur toute la périphérie des cellules (22).

7. Procédé selon l'une quelconque des revendications précédentes, **caractérisé en ce qu'**il comprend en outre une étape consistant à reporter pour chaque cellule (22) un motif tel qu'un index de tour d'heure (28) à la surface de l'électrode supérieure (18).

8. Procédé selon l'une quelconque des revendications précédentes, **caractérisé en ce que** chaque cellule (22) est en outre percée sensiblement en son centre, avant l'exécution de l'étape de dépôt des matériaux semi-conducteurs (16) et de la couche transparente ou semi-transparente de matériau électriquement conducteur.

9. Procédé selon l'une quelconque des revendications précédentes, **caractérisé en ce que** la couche desdits matériaux semi-conducteurs (16) est déposée selon un procédé au plasma, tandis que la couche transparente ou semi-transparente formant l'électrode supérieure (18) est déposée par évaporation sous vide.

10. Procédé selon l'une quelconque des revendications précédentes en dépendance de la revendication 1, **caractérisé en ce que** l'étape d'extraction consiste à appliquer une pression sur les cellules (22) du côté de leur électrode supérieure (18).

11. Procédé selon la revendication 10, **caractérisé en ce que**, préalablement à l'exécution de l'étape d'extraction, le procédé comprend les étapes supplémentaires consistant à :
- déposer une couche d'un matériau de protection (36) au-dessus de la couche formant l'électrode supérieure (18),
- éliminer la couche de protection (36) dans une zone périphérique de chaque cellule individuelle (22) afin d'exposer dans cette zone la couche transparente ou semi-transparente de matériau conducteur,
- éliminer la couche transparente ou semi-transparente de matériau conducteur de la zone périphérique,
- éliminer le matériau de protection (36) restant.

12. Procédé selon l'une quelconque des revendications précédentes, **caractérisé en ce qu'**il comprend une étape supplémentaire consistant à tester électriquement les cellules (22) avant l'étape d'extraction.

13. Procédé selon l'une quelconque des revendications précédentes en dépendance de la revendication 2, **caractérisé en ce que** l'étape de découpage est réalisée par étampage.

14. Procédé de fabrication selon l'une quelconque des revendications précédentes en dépendance de la revendication 2, **caractérisé en ce que** l'étape (d) comprend une étape consistant à déposer un matériau de protection (36) sur le ou les ponts de matière (30) préalablement au dépôt de la couche conductrice transparente ou semi-transparente, et à éliminer le matériau de protection (36) avec le matériau de la couche formant l'électrode supérieure (18) avant l'exécution de l'étape (f).

15. Procédé de fabrication selon l'une quelconque des revendications précédentes, **caractérisé en ce que** la bande (2) est réalisée en acier inoxydable.

## Claims

1. Batch manufacturing method for a plurality of individual photovoltaic cells (22), each cell (22) including:
- an electrically conductive substrate (2) forming a first electrode (4),
- a second transparent or semi-transparent electrode (18) and a photovoltaic semi-conductor body (16) forming the junction arranged between the first and the second electrodes (4, 18);
the method being **characterized in that** it includes at least the following steps:
(a) providing at least one strip (1) of conductive material,
(b) punching in succession in said strip (1) substrates (2) forming the lower electrodes (4) along a cutting line (6) substantially defining the shape and the dimensions of the desired cells (22),
(c) replacing the cut substrates (2) in the strip (1) in the locations where they were cut out,
(d) depositing on one of the faces (4a) of the strip (1) semi-conductor materials forming at least an n-i-p or p-i-n junction to form said photovoltaic semi-conductor body (16),
(e) depositing a transparent or semi-transparent layer of electrically conductive material on top of said semi-conductor materials to form an upper electrode (18),
(f) removing from the strip (1) the cut substrates (2) coated with said semi-conductor materials and the upper electrode (18) to form individual photovoltaic cells (22).

2. Batch manufacturing method for a plurality of individual photovoltaic cells (22), each cell (22) including:
- an electrically conductive substrate (2) forming a first electrode (4),
- a second transparent or semi-transparent electrode (18) and a photovoltaic semi-conductor body (16) disposed between the first and the second electrodes (4, 18),
the method being **characterized in that** it includes at least the following steps:
(a) providing at least one strip (1) of conductive material,
(b) cutting out in succession in said strip (1) substrates (2) which form the lower electrodes (4) for each cell (22) and which have the dimensions of the desired cells (22), so that each of said substrates (2) is connected to the rest of the strip (1) by at least one bridge of material (30),
(c) depositing semi-conductor materials forming at least one n-i-p or p-i-n junction (16) on one the faces (4a) of the strip (1),
(d) depositing a transparent or semi-transparent layer of an electrically conductive material on top of said semi-conductor materials (16) to form an upper electrode (18), except over the bridge or bridges of material (30),
(e) removing from the strip (1), by cutting the bridge or bridges of material (30) at the location which is not coated with said transparent or semi-transparent material, the substrates (2) coated with said semi-conductor materials (16) and the upper electrode (18) to form individual photovoltaic cells (22).

3. Method according to either of claims 1 and 2, **characterized in that** the strip (1) is cut into sections of strip (12) each including a predetermined number of substrates (2) prior to performance of the step of depositing the semi-conductor materials (16) and the transparent or semi-transparent layer of electrically conductive material.

4. Method according to any one of claims 1 to 3, **characterized in that** it further includes a step consisting in forming for each cell (22) a contact pad (26) for the upper electrode (18).

5. Method according to claim 4 when it depends on claim 1, **characterized in that** the contact pad (26) is arranged at the periphery of the cell (22) so that it does not extend above the cutting line (6).

6. Method according to either of claims 4 and 5, **characterized in that** the contact pads (26) are continuous and extend over the entire periphery of the cells (22).

7. Method according to any one of the preceding claims, **characterized in that** it further includes a step consisting in transferring a design such as an hour circle (28) onto the surface of the upper electrode (18) of each cell (22).

8. Method according to any one of the preceding claims, **characterized in that** each cell (22) is also pierced substantially at its centre, prior to performance of the step of depositing the semi-conductor materials (16) and the transparent or semi-transparent layer of electrically conductive material.

9. Method according to any one of the preceding claims, **characterized in that** the layer of said semi-conductor materials (16) is deposited by plasma, while the transparent or semi-transparent layer of electrically conductive material forming the upper electrode (18) is deposited by vapor deposition.

10. Method according to any one of the preceding claims when it depends on claim 1, **characterized in that** the removal step consists in applying pressure onto the cells (22) on the side of the upper electrode (18) thereof.

11. Method according to claim 10, **characterized in that**, prior to performance of the removal step, the method includes the additional steps consisting in:
- depositing a layer of protective material (36) on top of the layer forming the upper electrode (18),
- removing the protective layer (36) in a peripheral zone of each individual cell (22) in order to expose the transparent or semi-transparent layer of electrically conductive material in this zone,
- removing the transparent or semi-transparent layer of electrically conductive material from the peripheral zone,
- removing the remaining protective material (36).

12. Method according to any one of the preceding claims, **characterized in that** it includes an additional step consisting in electrically testing the cells (22) prior to the removal step.

13. Method according to any one of the preceding claims when it depends on claim 2, **characterized in that** the cutting step is performed by punching.

14. Manufacturing method according to any one of the preceding claims depending upon claim 2, **characterized in that** step (d) includes a step of depositing a protective material (36) on the bridge or bridges of material (30) prior to the deposition of the transparent or semi-transparent conductive material, and removing the protective material (36) with the material of the layer forming the upper electrode (18) prior to the performance of step (f).

15. Manufacturing method according to any one of the preceding claims, **characterized in that** the strip (2) is made of stainless steel.

## Patentansprüche

1. Verfahren zur gemeinsamen Herstellung eines Satzes von einzelnen photovoltaischen Zellen (22), wobei jede Zelle umfasst:
- ein elektrisch leitfähiges Substrat (2), welches eine erste Elektrode (4) bildet,
- eine zweite transparente oder semi-transparente Elektrode (18) und einen Körper (16) aus einem photovoltaischen Halbleiter, der einen Übergang zwischen der ersten und der zweiten Elektrode (4, 18) bildet,
wobei das Verfahren **dadurch gekennzeichnet ist, dass** es wenigstens die folgenden Schritte umfasst:
(a) bereitstellen wenigstens einen Streifens (1) aus einem leitfähigen Material,
(b) sukzessives ausstanzen von Substraten (2), welche untere Elektroden (4) bilden, entlang einer Schnittlinie (6), welche im Wesentlichen die Form und die Dimensionen von gewünschten Zellen festlegt,
(c) erneutes Anordnen der ausgeschnittenen Substrate (2) in dem Streifen (1) an den Stellen, an denen sie ausgeschnitten worden sind,
(d) aufbringen von Halbleitermaterialien, die wenigstens einen n-i-p-Übergang oder einen p-i-n-Übergang bilden, um den photovoltaischen Halbleiterkörper (16) zu bilden, auf eine der Seiten (4a) des Streifens (1),
(e) aufbringen einer transparenten oder semitransparenten Schicht eines elektrisch leitfähigen Materials oberhalb der Halbleitermaterialien, um eine obere Elektrode (18) zu bilden,
(f) herauslösen der mit den Halbleitermaterialien und der oberen Elektrode (18) versehenen ausgeschnittenen Substrate (2) aus dem Streifen (1), um einzelne photovoltaische Zellen zu bilden.

2. Verfahren zur gemeinsamen Herstellung eines Satzes von einzelnen photovoltaischen Zellen (22), wobei jede Zelle umfasst:
- ein elektrisch leitfähiges Substrat (2), welches eine erste Elektrode (4) bildet,
- eine zweite transparente oder semi-transparente Elektrode (18) und einen Körper (16) aus einem photovoltaischen Halbleiter, der einen Übergang zwischen der ersten und der zweiten Elektrode (4, 18) bildet,
wobei das Verfahren **dadurch gekennzeichnet ist, dass** es wenigstens die folgenden Schritte umfasst:
(a) bereitstellen wenigstens einen Streifens (1) aus einem leitfähigen Material,
(b) sukzessives ausschneiden von Substraten (2), welche die unteren Elektroden (4) für jede Zelle (22) bilden und die Form und die Dimensionen von gewünschten Zellen besitzen, aus dem Streifen (1), derart, dass jedes der Substrate (2) über wenigstens eine Materialbrücke (3) mit dem Rest des Streifens (1) verbunden ist,
(c) aufbringen von Halbleitermaterialien, die wenigstens einen n-i-p-Übergang oder einen p-i-n-Übergang (16) bilden, auf eine der Seiten (4a) des Streifens (1),
(d) aufbringen einer transparenten oder semi-transparenten Schicht eines elektrisch leitfähigen Materials oberhalb der Halbleitermaterialien (16) mit Ausnahme der Materialbrücken (30), um eine obere Elektrode (18) zu bilden,
(e) herauslösen der mit den Halbleitermaterialien (16) versehenen ausgeschnittenen Substrate (2) und der oberen Elektrode (18) aus dem Streifen (1) durch Ausschneiden der nicht von der transparenten oder semi-transparenten Schicht verdeckten Materialbrücke bzw. -brücken (30), um einzelne photovoltaische Zellen zu bilden.

3. Verfahren nach einem der Ansprüche 1 oder 2, **dadurch gekennzeichnet, dass** der Streifen (1) in Stege (12) geschnitten wird, die jeweils eine vorbestimmte Anzahl von Substraten (2) umfassen, bevor der Schritt des Aufbringens von Halbleitermaterialien (16) und der transparenten oder semi-transparenten Schicht eines elektrisch leitfähigen Materials durchgeführt wird.

4. Verfahren nach einem der Ansprüche 1 bis 3, **dadurch gekennzeichnet, dass** es ferner einen Schritt umfasst, der daraus besteht, dass für jede Zelle (22) ein Kontaktbereich (26) als Kontakt mit der oberen Elektrode (18) ausgebildet wird.

5. Verfahren nach Anspruch 4 abhängig von Anspruch 1, **dadurch gekennzeichnet, dass** der Kontaktbereich (26) so in einem Randbereich der Zelle (22) ausgebildet wird, dass er sich nicht über die Schnittlinie (6) hinaus erstreckt.

6. Verfahren nach einem der Ansprüche 4 oder 5, **dadurch gekennzeichnet, dass** die Kontaktbereiche (26) kontinuierlich sind und sich über den gesamten Randbereich der Zellen (22) erstrecken.

7. Verfahren nach einem der vorstehenden Ansprüche, **dadurch gekennzeichnet, dass** es ferner einen Schritt umfasst, der daraus besteht, dass für jede Zelle ein Motiv wie eine Anzeige für eine Stundenumdrehung (28) auf die Oberfläche der oberen Elektrode (18) übertragen wird.

8. Verfahren nach einem der vorstehenden Ansprüche, **dadurch gekennzeichnet, dass** ferner jede Zelle (22) im Wesentlichen in ihrer Mitte durchbohrt wird, bevor der Schritt des Aufbringens von Halbleitermaterialien (16) und der transparenten oder semi-transparenten Schicht eines elektrisch leitfähigen Materials durchgeführt wird.

9. Verfahren nach einem der vorstehenden Ansprüche, **dadurch gekennzeichnet, dass** die Schicht der Halbleitermaterialien mit einem Plasma-Verfahren aufgebracht wird, während die transparente oder semi-transparente Schicht, welche die obere Elektrode (18) bildet, mittels einer Verdampfung im Vakuum aufgebracht wird.

10. Verfahren nach einem der vorstehenden Ansprüche abhängig von Anspruch 1, **dadurch gekennzeichnet, dass** der Schritt des Herauslösens darin besteht, dass ein Druck auf die Zellen auf der Seite ihrer oberen Elektrode (18) ausgeübt wird.

11. Verfahren nach Anspruch 10, **dadurch gekennzeichnet, dass** es vor der Durchführung des Schrittes des Herauslösens folgende zusätzliche Schritte umfasst:
- aufbringen einer Schicht eines Schutzmaterials (36) oberhalb der die obere Elektrode (18) bildenden Schicht,
- entfernen der Schutzschicht in einem Randbereich jeder einzelnen Zelle (22), um in diesem Bereich die transparente oder semi-transparente Schicht eines elektrisch leitfähigen Materials freizulegen,
- entfernen der transparenten oder semi-transparenten Schicht eines elektrisch leitfähigen Materials in dem Randbereich,
- entfernen des verbleibenden Schutzmaterials (36).

12. Verfahren nach einem der vorstehenden Ansprüche, **dadurch gekennzeichnet, dass** es einen zusätzlichen Schritt aufweist, welcher darin besteht, die Zellen (22) vor dem Schritt des Herauslösens elektrisch zu testen.

13. Verfahren nach einem der vorstehenden Ansprüche abhängig von Anspruch 2, **dadurch gekennzeichnet, dass** der Schritt des Ausschneidens durch ein Ausstanzen umgesetzt wird.

14. Verfahren nach einem der vorstehenden Ansprüche abhängig von Anspruch 2, **dadurch gekennzeichnet, dass** der Schritt (d) einen Schritt umfasst, der darin besteht, ein Schutzmaterial auf die Materialbrücke bzw. -brücken (39) aufzubringen, bevor die transparente oder semi-transparente leitfähige Schicht aufgebracht wird, und das Schutzmaterial mit dem Material der die obere Elektrode (18) bildenden Schicht vor der Durchführung des Schrittes (f) zu entfernen.

15. Verfahren nach einem der vorstehenden Ansprüche, **dadurch gekennzeichnet, dass** der Streifen (2) aus rostfreiem Stahl ausgebildet ist.
